# EUROPEAN PATENT SPECIFICATION

(11) **EP 1 000 371 B1**
(45) Date of publication and mention of the grant of the patent: **13.12.2017**
(21) Application number: 98942028.6
(22) Date of filing: 07.08.1998
(51) Int. Cl.: G02B 1/00

(54) **ULTRA-BROADBAND UV MICROSCOPE IMAGING SYSTEM WITH WIDE RANGE ZOOM CAPABILITY**
ULTRABREITBAND UV-MIKROSKOP-ABBILDUNGSSYSTEM MIT WEITREICHENDER ZOOMFÄHIGKEIT
SYSTEME D'IMAGERIE COMPRENANT UN MICROSCOPE A U.V. A TRES GRANDE LARGEUR DE BANDE ET A EFFET DE ZOOM A GRANDE PORTEE

(30) Priority: 07.08.1997 US 908247
(43) Date of publication of application: 17.05.2000
(73) Proprietor: KLA-Tencor Corporation, San Jose, CA 95161 (US)
(72) Inventor: SHAFER, David, Ross, Fairfield, CT 06430 (US); CHUANG, Yung-Ho, Cupertino, CA 95014 (US); TSAI, Bin-Ming, Benjamin, Saratoga, CA 95070 (US)
(74) Representative: FRKelly
(86) International application number: PCT/US1998/016568
(87) International publication number: WO 1999/008134

(56) References cited:
- WO-A-96/29630
- US-A- 4 812 021
- US-A- 4 971 428
- US-A- 4 971 428
- US-A- 4 988 858
- US-A- 5 488 229
- US-A- 5 650 877

## Description

### BACKGROUND OF THE INVENTION

### 1. Field of the Invention

This invention relates generally to an ultra-broadband ultraviolet (UV) catadioptric imaging microscope system, and more specifically to an imaging system that comprises a UV catadioptric objective lens group and a wide-range zooming tube lens group.

### 2. Description of the Prior Art

Catadioptric imaging systems for the deep ultraviolet spectral region (about 0.19 to 0.30 micron wavelength) are known. U.S. Pat. No. 5,031,976 to Shafer and U.S. Pat. No. 5,488,229 to Elliott and Shafer disclose two such systems. These systems employ the Schupmann achromatic lens principle and the Offner-type field lens. Axial color and primary lateral color are corrected, but not higher order lateral color. This is the limiting aberration in these systems when a broad spectral range is covered.

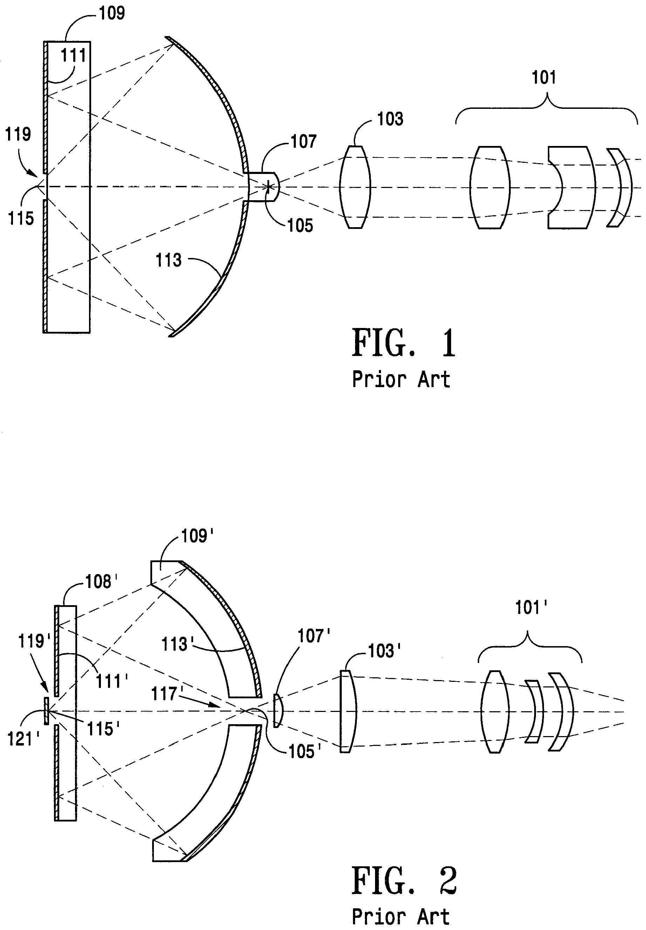

The above-noted '976 Shafer patent discloses an optical system based on the Schupmann achromatic lens principle which produces an achromatic virtual image. A reflective relay then creates an achromatic real image from this virtual image. The system, reproduced here as FIG. 1, includes an aberration corrector group of lenses 101 for correcting image aberrations and chromatic variation of image aberrations, a focusing lens 103 for receiving light from the group 101 and producing an intermediate image at plane 105, a field lens 107 of the same material as the other lenses placed at the intermediate image plane 105, a thick lens 109 with a plane mirror back coating 111 whose power and position are selected to correct the primary longitudinal color of the system in conjunction with the focusing lens 103, and a spherical mirror 113 located between the intermediate image plane and the thick lens 109 for producing a final image 115. Most of the focusing power of the system is due to the spherical mirror 113 which has a small central hole near the intermediate image plane 105 to allow light form the intermediate image plane 105 to pass through to the thick lens 109. The mirror coating 111 on the back of the thick lens 109 also has a small central hole 119 to allow light focused by the spherical mirror 113 to pass through to the final image 115. While primary longitudinal (axial) color is corrected by the thick lens 109, the Offner-type field lens 107 placed at the intermediate image 105 has a positive power to correct secondary longitudinal color. Placing the field lens slightly to one side of the intermediate image 105 corrects tertiary longitudinal color. Thus, axial chromatic aberrations are completely corrected over a broad spectral range. The system also incidentally corrects for narrow band lateral color, but fails to provide complete corrections of residual (secondary and higher order) lateral color over a broad UV spectrum.

The above-noted '229 patent to Elliott and Shafer provides a modified version of the optical system of the '976 patent, which has been optimized for use in .193 micron wavelength high power excimer laser applications such as ablation of a surface 121' as seen in FIG. 2. This prior art system has an aberration corrector group 101', focusing lens 103', intermediate focus 105', field lens 107', thick lens 109', mirror surfaces 111' and 113' with small central opening 117' and 119' therein and a final focus 115' as in the prior '976 patent, but repositions the field lens 107' so that the intermediate image or focus 105' lies outside of the field lens 107' to avoid thermal damage from the high power densities produced by focusing the excimer laser light. Further, both mirror surfaces 111' and 113' are formed on lens elements 108' and 109'. The combination of all light passing through both lens elements 108' and 109' provides the same primary longitudinal color correction of the single thick lens 109 in FIG. 1, but with a reduction in total glass thickness. Since even fused silica begins to have absorption problems at the very short 0.193 micron wavelength, the thickness reductions is advantageous at this wavelength for high power levels. Though the excimer laser source used for this optical system has a relatively narrow spectral line width, the dispersion of silica near the 0.193 micron wavelength is great enough that some color correction is still needed. Both prior art systems have a numerical aperture of about 0.6.

Longitudinal chromatic aberration (axial color) is an axial shift in the focus position with wavelength. The prior art system seen in FIG. 1 completely corrects for primary, secondary and tertiary axial color over a broad wavelength band in the near and deep ultraviolet (0.2 micron to 0.4 micron region). Lateral color is a change in magnification or image size with wavelength, and is not related to axial color. The prior art system of FIG. 1 completely corrects for primary lateral color, but not for residual lateral color. This is the limiting aberration in the system when a broad spectral range is covered.

U.S. Pat. No. 5,717,518 is for a catadioptric UV imaging system with performance improved over the systems of the above-describe patents. This system employs an achromatized field lens group to correct for secondary and higher order lateral color, which permits designing a high NA, large field, ultra-broadband UV imaging system.

Further, U.S. Pat. No. 4,971,428 discloses another catadioptric zoom lens. The catadioptric zoom lens comprises from the object end a first catadioptric group including a relay sub-group for forming an intermediate image, a zoom relay, the zoom relay including a positive variator group and a negative power compensator group. The variator group comprises a first sub-unit of weak power contributing to correction of coma and a second sub-unit providing most of the positive power of the variator group.

Zooming systems in the visible wavelengths are well-known. They either do not require very high levels of correction of higher-order color effects over a broad spectral region, or do require correction, but accomplish this by using three or more glass types. In the deep UV, there are very few materials that can be used for chromatic aberration correction, making the design of high performance, broadband optics difficult. It is even more difficult to correct for chromatic aberrations for ultra-broadband optics with wide-range zoom.

There remains, therefore, a need for an ultra-broadband UV microscope imaging system with wide-range zoom capability.

### SUMMARY OF THE INVENTION

The invention is defined in the appended claims. The present invention has an object to provide a catadioptric imaging system which corrects for image aberrations, chromatic variation of image aberrations, longitudinal (axial) color and lateral color, including residual (secondary and higher order) lateral color correction over an ultra-broad spectral range in the near and deep UV spectral band (0.2 to 0.4 micron).

Another object is to provide an UV imaging system, useful as a microscope or as micro-lithography optics, with a large numerical aperture of 0.9'and with a field of view of at least one millimeter. The system is preferably tele-centric. An embodiment of the invention is a high performance, high numerical aperture, ultra-broad spectral region catadioptric optical system with zooming capability, comprising an all-refractive zooming tube lens section with one collimated conjugate, constructed so that during zooming its higher-order chromatic aberrations (particularly higher-order lateral color) do not change; and a non-zooming high numerical aperture catadioptric objective section which compensates for the uncorrected (but stationary during zoom) higher-order chromatic aberration residuals of the zooming tube lens section.

These and other objects and advantages of the present invention will become apparent to those skilled in the art from the following detailed description and accompanying drawings.

### BRIEF DESCRIPTION OF THE DRAWINGS

FIG. 1 is a prior art system that completely corrects for primary, secondary and tertiary axial color over a broad wavelength band in the near and deep ultraviolet (0.2 micron to 0.4 micron), but not for residual lateral color;
FIG. 2 is a modified version of the '976 Shafer patent optimized for use in .193 micron wavelength high power excimer laser applications;
FIG. 3 is a schematic side view of a catadioptric imaging system in accord with the parent application;
FIG. 4 is a schematic side view of a catadioptric imaging system in accordance with the present invention;
FIG. 5 is schematic side view of a catadioptric imaging system in the three positions having 36X, 64X and 100X power magnifications in accordance with a first embodiment of the invention;
FIG. 6 is a schematic side view of a catadioptric imaging system in three positions having 36X, 64X and 100X power magnifications in accordance with a second embodiment of invention;
FIG. 7 is a schematic side view of a catadioptric imaging system in three positions having 36X, 64X and 100X power magnification in accordance with a third embodiment of the invention; and
FIG. 8 is a schematic side view of a zooming catadioptric imaging system in an application for the inspection of semiconductor wafers.

### DETAILED DESCRIPTION OF THE PREFERRED EMBODIMENT

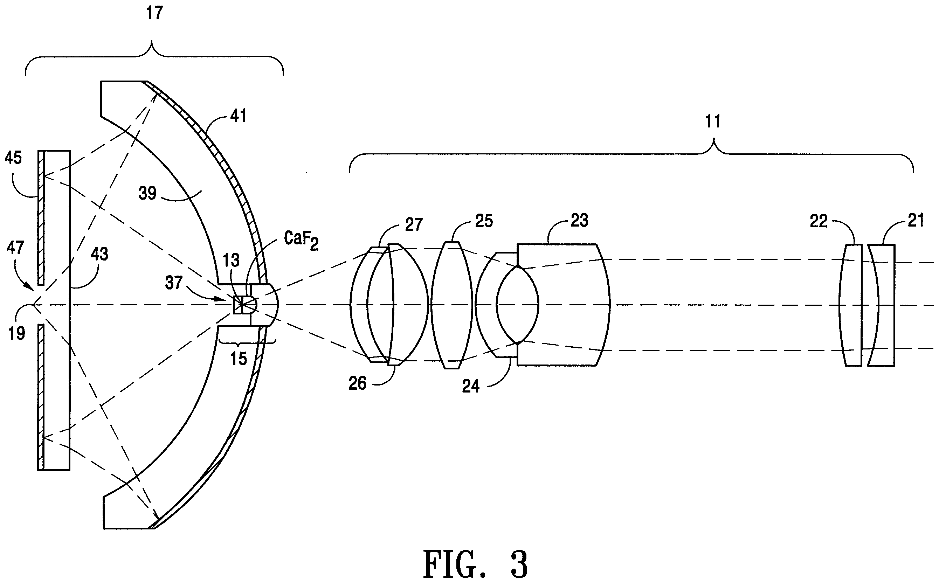

FIG. 3 shows a catadioptric imaging system of the parent invention, which is especially suited for use in broadband deep ultraviolet applications and is made up of a focusing lens group 11 for forming an intermediate image 13, a field lens group 15 disposed proximate to the intermediate image 13 for correcting chromatic aberrations, and a catadioptric group 17 for focusing light from the intermediate image 13 to a final image 19. The imaging system is optimized to correct both monochromatic (Seidel) aberrations and chromatic aberrations (longitudinal and lateral), as well as chromatic variations of the monochromatic aberrations, over a wavelength band that extends into the deep ultraviolet (UV) portion of the spectrum, covering 0.20 to 0.40 micron UV light. The catadioptric system of the parent invention can be adapted for a number of UV imaging applications, including as a UV microscope objective, a collector of surface scattered UV light in a wafer inspection apparatus, or as mask projection optics for a UV photolithography system.

The focusing lens group 11 in FIG. 3 consists of seven lens elements 21-27, with two of the lens elements (21 and 22) separated by a substantial distance from the remaining five lens elements (23-27). The separations of the pair of lens elements 21 and 22 from the remaining five lens elements 23-27 is typically on the order of at least one-half the total combined thickness of the five lens elements 23-27. For example, lens elements 23-27 may span a distance of about 60 millimeters (mm) and lens element 22 may be 30 to 60 mm from lens element 23. The actual dimensions depend on the scale chosen for the embodiment. The two lenses 21 and 22 form a low power doublet for correcting chromatic variation of monochromatic image aberrations, such as coma and astigmatism. By having this doublet 21 and 22 relatively far from the other system components, the shift of the light beam with field angles on these two lenses is maximized. That in turn helps greatly in achieving the best correction of chromatic variation of aberrations.

The five lenses 23-27 of the main focusing subgroup consist of a thick strong negative meniscus lens 23, an opposite-facing strongly-curved negative meniscus lens 24, a strong bi-convex lens 25, a strong positive meniscus lens 26, and an opposite-facing strongly-curved, but very weak, meniscus lens 27 of either positive or negative power. Variations of this lens 23-27 subgroup are possible. The subgroup focuses the light to an intermediate image 13. The curvature and positions of the lens surfaces are selected to minimize monochromatic aberrations and to cooperate with the doublet 21-22 to minimize chromatic variations of those aberrations.

The field lens group 15 typically comprises an achromatic triplet, although any achromatized lens group can be used. Both fused silica and CaF₂ glass materials are used. Other possible deep UV transparent refractive materials can include MgF₂, SrF₂, LaF₃ and LiF glasses, or mixtures thereof. In addition to refractive materials, diffractive surfaces can be used to correct chromatic aberrations. Because the dispersions between the two UV transmitting materials, CaF₂ glass and fused silica, are not very different in the deep ultraviolet, the individual components of the group 15 have strong curvatures. Primary color aberrations are corrected mainly by the lens elements in the catadioptric group 17 in combination with the focusing lens group 11. Achromatization of the field lens group 15 allows residual lateral color to be completely corrected.

The catadioptric group 17 of FIG. 3 includes a fused silica meniscus lens 39 with a back surface having coating 41, and fused silica lens 43 with a back surface having a reflective coating 45. The two lens elements 39 and 43 front surfaces face each other. The reflective surface coating 41 and 45 are typically aluminum, possibly with a dielectric overcoat to enhance reflectivity.

The first lens 39 has a hole 37 centrally formed therein along the optical axis of the system. The reflective coating 41 likewise ends at the central hole 37 leaving a central optical aperture through which light can pass unobstructed by either the lens 39 or its reflective coating 41. The optical aperture defined by the hole 37 is in the vicinity of the intermediate image plane 13 so that there is minimum optical loss. The achromatic field lens group 15 is positioned in or near the hole 37. The second lens 43 does not normally have a hole, but there is a centrally located opening or window 47 where the coating is absent on the surface reflective coating 45. The optical aperture in lens 39 with its reflective coating 41 need not be defined by a hole 37 in the lens 39, but could be defined simply by a window in the coating 41 as in coating 45. In that case, light would pass one additional time through the refractive surfaces of lens 39.

Light from the source transmitted along the optical axis toward the intermediate image plane 13 passes through the optical aperture 37 in the first lens 39 and then through the body of the second lens 43 where it is reflected by the near planar (or planar) mirror coating 45 back through the body of the second lens 43. The light then passes through the first lens 39, is reflected by the mirror surface 41 and passes back through the first lens 39. Finally the light, now strongly convergent passes through the body of the second lens 43 for a third time, through the optical aperture 47 to the target image plane adjacent aperture 47. The curvatures and positions of the first and second lens surfaces are selected to correct primary axial and lateral color in conduction with the focal lens group 11.

For a flexible deep UV microscope system, it is important to provide various magnifications, numerical apertures, field sizes, and colors. In principle, an UV microscope system can comprise several catadioptric objectives, tube lenses, and zoom lenses. However, several problems are encountered when designing a complete microscope system. First, the microscope design needs to accommodate many large size catadioptric objectives to provide different magnifications and numerical apertures. Second, in order to maintain image quality, chromatic variation of aberrations of each tube lens must be corrected to the same degree as the objective itself. Third, the chromatic variation of aberrations of a zooming system must be corrected over the full range of zoom. These problems are addressed by the present invention.

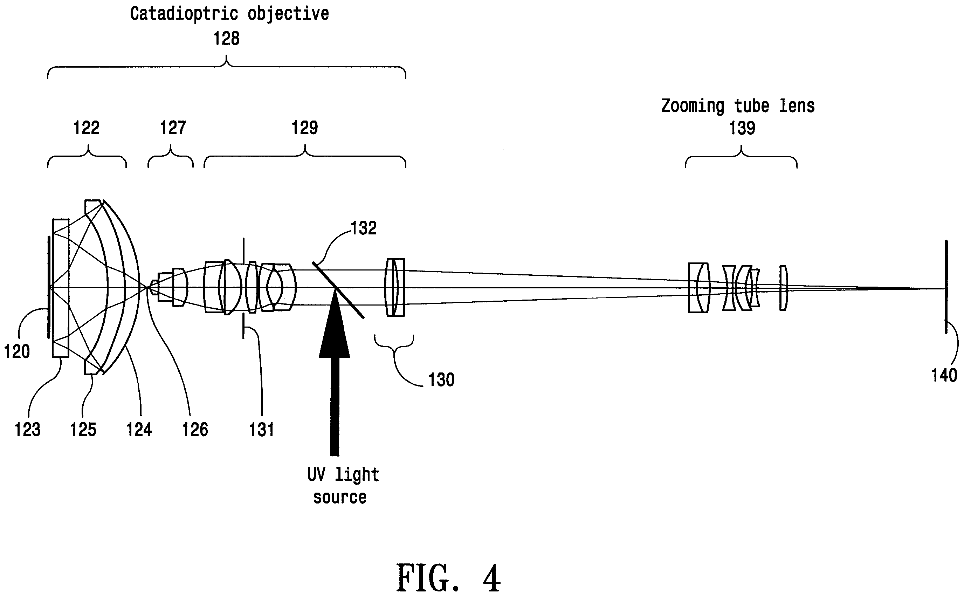

An ultra-broadband UV microscope imaging system according to the present invention as illustrated in FIG. 4 comprises a catadioptric objective section 128 and a zooming tube lens group sections 139. The catadioptric objective section 128 comprises a catadioptric lens group 122, a field lens group 127, a focusing lens group 129. The beam splitter 132 provides an entrance for the UV light source. The aperture stop 131 is used to adjust the system imaging numerical aperture (NA). The microscope system images an object 120 (e.g., a wafer being inspected) to the image plane 140. The complete 0.9 NA catadioptric objective section 128 is also described in the parent patent application.

The catadioptric objective section 128 is optimized for ultra-broadband imaging in the UV spectral region (about 0.20 to 0.40 micron wavelength). It has excellent performance for high numerical apertures and large object fields. This invention uses the Schupmann principle in combination with an Offner field lens to correct for axial color and first order lateral color, and an achromatized field lens group to correct the higher order lateral color. The elimination of the residual higher order chromatic aberrations makes the ultra-broadband UV objective design possible.

The catadioptric lens group 122 includes a near planar or planar reflector 123, which is a reflectively coated lens element, a meniscus lens 125, and a concave spherical reflector. Compared to the reflectively coated lens element 39 in FIG. 3, the preferred embodiment uses a concave reflector 124 and a large meniscus lens 125 to simplify manufacturing. Both reflective elements have central optical apertures without reflective material to allow light from the intermediate image plane 126 to pass through the concave reflector, be reflected by the near planar (or planar) reflector 123 onto the concave reflector 124, and pass back through the near planar (or planar) reflector 123, traversing the associated lens element or elements on the way.

The achromatic multi-element field lens group 127 is made from two or more different refractive materials, such as fused silica and fluoride glass, or diffractive surfaces. The field lens group 127 may be optically coupled together or alternatively may be spaced slightly apart in air. Because fused silica and fluoride glass do not differ substantially in dispersion in the deep ultraviolet range, the individual powers of the several component element of the field lens group need to be of high magnitude. Use of such an achromatic field lens allows the complete correction of axial color and lateral color over an ultra-broad spectral range. In the simplest version of the design, only one field lens component need be of a refractive material different than the other lenses of the system. Compared to group 15 in FIG. 3, the field lens group 127 is moved slightly from the intermediate image location to reduce the heat load and surface scattering of the field lens group.

The present embodiment has a focusing lens group 129 with multiple lens elements, preferably all formed from a single type of material, with refractive surfaces having curvatures and positions selected to correct both monochromatic aberrations and chromatic variation of aberrations and focus light to an intermediate image. In the focusing lens group 129 a special combination of lenses 130 with low power corrects the system for chromatic variation in spherical aberration, coma, and astigmatism.

Design features of the field lens group 127 and the low power group 130 are key to the present invention. The zooming tube lens 139 combined with the catadioptric objective 128 provides many desirable features. Such an all-refractive zooming lens ideally will allow the detector array 140 to be stationary during zooming, although the invention is not limited to this preferred embodiment. Assuming that the catadioptric objective system 128 does not also have any zooming function, there are two design possibilities open to the zooming tube lens system 139.

First, the zooming section 139 can be all the same refractive material, such as fused silica, and it must be designed so that primary longitudinal and primary lateral color do not change during zooming. These primary chromatic aberrations do not have to be corrected to zero, and cannot be if only one glass type is used, but they have to be stationary, which is possible. Then the design of the catadioptric objective 128 must be modified to compensate for these uncorrected but stationary chromatic aberrations of the zooming tube lens. This can be done, but a solution is needed with good image quality. Despite the limited image quality, this design possibility is very desirable since the whole combined microscope system is a single material, i.e., fused silica, except for the calcium fluoride or a diffractive surface in the achromatized Offner-type field lens.

Second, the zooming tube lens group 139 can be corrected for aberrations independently of the catadioptric objective 128. This requires the use of at least two refractive materials with different dispersions, such as fused silica and calcium fluoride, or diffractive surfaces. Unfortunately, the result is a tube lens system that, because of unavoidable higher-order residuals of longitudinal and lateral color over the entire zoom range, is not capable of high performance over a very broad UV spectral region. Compromises must then be made in the form of reducing the spectral range, the numerical aperture, the field size of the combined system, or some combination of these compromises. The result is that the very high capabilities of the catadioptric objective cannot be duplicated with an independently corrected zooming tube lens.

The present invention straddles the two situations just described. In the present embodiment, the zooming tube lens 139 is first corrected independently of the catadioptric objective 128, using two refractive materials (such as fused silica and calcium fluoride). Lens 139 is then combined with the catadioptric objective 128 and then the catadioptric objective is modified to compensate for the residual higher-order chromatic aberrations of the zooming tube lens system. This is possible because of the design features of the field lens group 127 and the low power lens group 130 of the catadioptric objective described earlier. The combined system is then optimized with all parameters being varied to achieve the best performance.

One unique feature of the present invention is the particular details of the zooming tube lens. If the higher-order residual chromatic aberrations of this zooming system change during zoom, then the catadioptric objective cannot exactly compensate for them except at one zoom position. It is easy to design a zooming tube lens system where the low-order chromatic aberrations do not change during zoom, and are corrected to zero as well. But it is very difficult to find a zooming tube lens design where the higher-order chromatic aberration residuals (which are uncorrectable to zero, in that system by itself) do not change during the zooming.

A tube lens section can be designed such that its higher-order chromatic aberrations do not change by any significant amount during zoom. If the detector array 140 is allowed to move during zoom, then the design problem becomes much easier, but that is not nearly as desirable as having an image position fixed relative to the rest of the system.

The imaging system of the invention provides a zoom from 36X to 100X and greater, and integrates objectives, turret, tube lenses (to provide more magnifications) and zoom optics into one module. The imaging system reduces optical and mechanical components, improves manufacturability and reduces production costs. The imaging system has several performance advantages such as: high optical resolution due to deep UV imaging, reduced thin film interference effects due to ultra-broadband light, and increased light brightness due to integration of ultra-broad spectral range. The wide range zoom provides continuous magnification change. The fine zoom reduces aliasing and allows electronic image processing, such as cell-to-cell subtraction for a repeating image array. By placing an adjustable aperture in the aperture stop of the microscope system one can adjust the NA and obtain the desired optical resolution and depth of focus. The invention is a flexible system with an adjustable wavelength, an adjustable bandwidth, an adjustable magnification, and an adjustable numerical aperture.

There are three possible embodiments of zoom lenses. The first embodiment provides linear zoom motion with a fixed detector array position. The second embodiment provides linear zoom motion with a moving detector array position. The third embodiment, in addition to zoom lenses, utilizes folding mirrors to reduce the physical length of the imaging system and fix the detector array position.

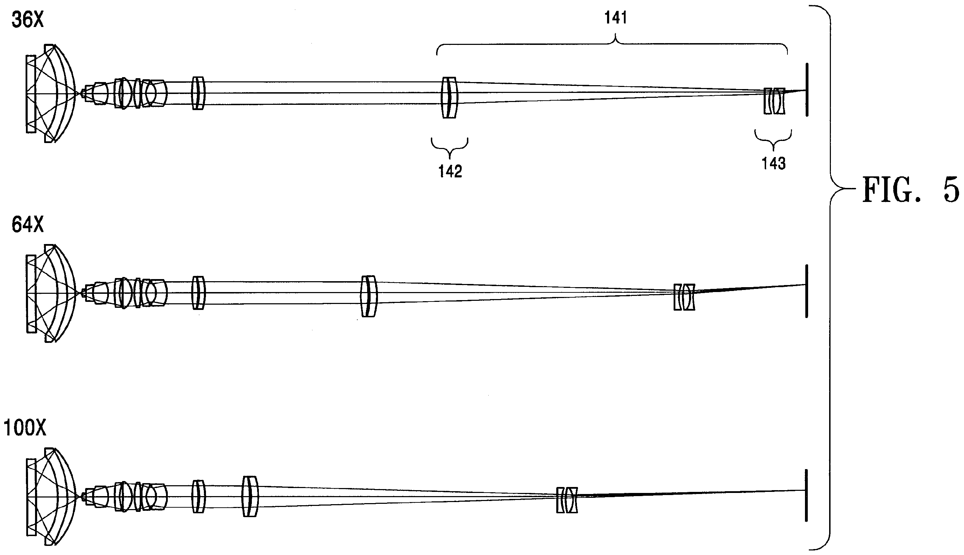

The first embodiment of zoom lenses provides linear zoom motion with a fixed detector array position. FIG. 5 shows the 36X zoom arrangement of the lenses, the 64X zoom arrangement of the lenses and the 100X zoom arrangement of the lenses. The detector array 140 (not shown) is fixed. The zooming tube lens design 141 is comprised of two moving lens groups 142 and 143. The beam splitter is not shown in this and later figures for the purpose of clarity. The following table lists the surfaces shown in FIG. 5, where the surface numbering begins at "0" for the final image counting towards the object being inspected.

**Lens Data for the First Embodiment**

| 0.90 N.A., fixed detector, 36X -100X zoom, 1.0 mm field size | | | | |
|---|---|---|---|---|
| Surface | Radius | Thickness | | Glass |
| 0 | -- | 30.000000 | 36X | Air |
| | | 152.396279 | 64X | |
| | | 318.839746 | 100X | |
| 1 | -46.843442 | 4.000000 | | Calcium fluoride |
| 2 | 67.017379 | 0.999804 | | Air |
| 3 | 122.003494 | 7.000000 | | Silica |
| 4 | -34.944144 | 4.496612 | | Air |
| 5 | -42.883889 | 4.000000 | | Calcium fluoride |
| 6 | -1.5857e+03 | 339.659737 | 36X | Air |
| | | 298.114540 | 64X | |
| | | 279.997392 | 100X | |
| 7 | -657.423731 | 9.000000 | | Calcium fluoride |
| 8 | -67.124645 | 0.999689 | | Air |
| 9 | -70.484550 | 6.000000 | | Silica |
| 10 | 102.732012 | 28.382549 | | Air |
| 11 | 170.942101 | 13.000000 | | Calcium fluoride |
| 12 | -126.768482 | 274.177371 | 36X | Air |
| | | 193.326289 | 64X | |
| | | 44.999970 | 100X | |
| 13 | 103.846671 | 5.000000 | | Silica |
| 14 | 57.151413 | 3.500000 | | Air |
| 15 | 113.406488 | 7.000000 | | Silica |
| 16 | -149.254887 | 58.301706 | | Air |
| 17 | 41.730749 | 14.904897 | | Silica |
| 18 | 17.375347 | 11.364798 | | Air |
| 19 | -22.828011 | 5.892666 | | Silica |
| 20 | -57.773872 | 1.000000 | | Air |
| 21 | 174.740180 | 7.000000 | | Silica |
| 22 | -48.056749 | 4.000000 | | Air |
| 23 | 24.023380 | 11.500000 | | Silica |
| 24 | -1.0394e+03 | 4.198255 | | Air |
| 25 | -43.531092 | 5.000000 | | Silica |
| 26 | -197.030499 | 1.000000 | | Air |
| 27 | 45.618003 | 29.827305 | | Silica |
| 28 | -81.744432 | 1.662262 | | Air |
| 29 | 17.258988 | 4.000000 | | Calcium fluoride |
| 30 | -31.010978 | 0.315372 | | Air |
| 31 | -24.055515 | 2.000000 | | Silica |
| 32 | 5.602559 | 0.020000 | | Air |
| 33 | 5.602559 | 8.318486 | | Calcium fluoride |
| 34 | -24.871116 | 7.710304 | | Air |
| 35 | -- | 8.328925 | | Air |
| Aperture Stop | | | | |
| 36 | 85.000000 | 11.000000 | | Silica |
| 37 | 70.542512 | 29.938531 | | Air |
| 38 | 1.6514e+03 | 10.000000 | | Silica |
| 39 | Infinity | -10.000000 | | Reflect |
| 40 | 1.6514e+03 | -29.938531 | | Air |
| 41 | 70.542512 | -11.000000 | | Silica |
| 42 | 85.000000 | -8.328925 | | Air |
| 43 | 74.648515 | 8.328925 | | Reflect |
| 44 | 85.000000 | 11.000000 | | Silica |
| 45 | 70.542512 | 29.938531 | | Air |
| 46 | 1.6514e+03 | 10.000000 | | Silica |
| 47 | Infinity | 1.500000 | | Air |

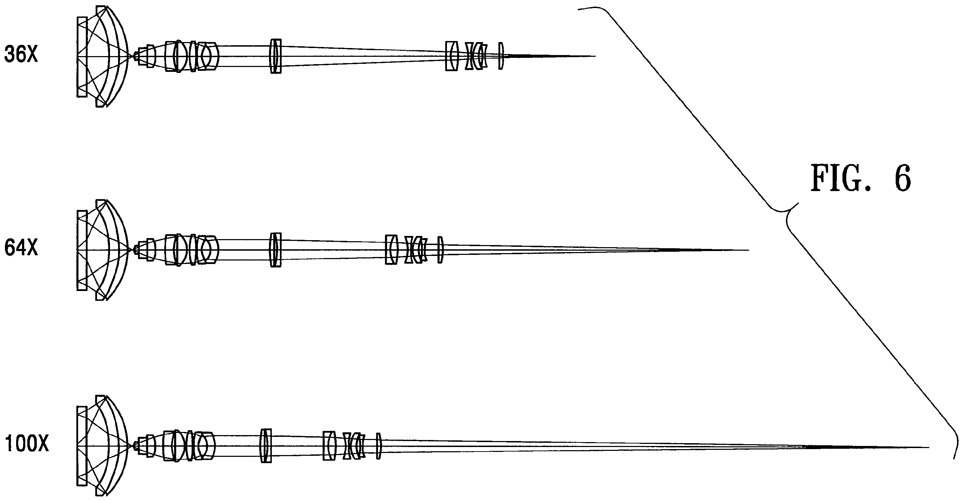

The second embodiment of zoom lenses provides linear zoom motion with a moving detector array position and FIG. 6 shows the 36X zoom arrangement of the lenses, the 64X zoom arrangement of the lenses and the 100X zoom arrangement of the lenses. The following table lists the surfaces shown in FIG. 6, where the surface numbering begins at "0" for the final image incrementing by 1 towards the object being inspected.

**Lens Data for the Second Embodiment**

| 0.90 N.A., moving detector, 36X to 100X zoom, 1.0 mm field size | | | | |
|---|---|---|---|---|
| SURFACE | RADIUS | THICKNESS | | GLASS |
| 0 | Infinity | 110.004950 | 36X | Air |
| | | 405.371660 | 64X | |
| | | 785.131189 | 100X | |
| 1 | 73.156621 | 5.000000 | | Calcium fluoride |
| 2 | -609.638437 | 18.230155 | | Air |
| 3 | -30.303090 | 3.500000 | | Calcium fluoride |
| 4 | 44.361656 | 4.000000 | | Air |
| 5 | -51.318999 | 7.765282 | | Silica |
| 6 | -23.231195 | 1.564401 | | Air |
| 7 | -119.756315 | 4.000000 | | Calcium fluoride |
| 8 | 40.002701 | 12.019418 | | Air |
| 9 | 54.594789 | 10.000000 | | Calcium fluoride |
| 10 | -28.923744 | 0.100000 | | Air |
| 11 | -29.957411 | 5.000000 | | Silica |
| 12 | -156.281481 | 202.434836 | 36 X | Air |
| | | 108.230318 | 64X | |
| | | 64.650627 | 100X | |
| 13 | 188.664770 | 4.500000 | | Silica |
| 14 | 56.034008 | 3.500000 | | Air |
| 15 | 214.395300 | 6.000000 | | Silica |
| 16 | -79.842174 | 62.685096 | | Air |
| 17 | 29.721624 | 10.000000 | | Silica |
| 18 | 18.529920 | 11.406390 | | Air |
| 19 | -23.406055 | 5.864347 | | Silica |
| 20 | -46.076628 | 1.000000 | | Air |
| 21 | 94.310969 | 7.000000 | | Silica |
| 22 | -75.041727 | 4.000000 | | Air |
| 23 | 23.509091 | 11.500000 | | Silica |
| Aperture stop | | | | |
| 24 | -399.710365 | 4.516455 | | Air |
| 25 | -42.987793 | 10.000000 | | Silica |
| 26 | -217.407455 | 12.083912 | | Air |
| 27 | 24.940148 | 10.000000 | | Calcium fluoride |
| 28 | -177.604306 | 0.100000 | | Air |
| 29 | 24.508018 | 10.000000 | | Calcium fluoride |
| 30 | -54.909641 | 0.664880 | | Air |
| 31 | -16.389836 | 2.000000 | | Silica |
| 32 | 4.296836 | 0.020000 | | Air |
| 33 | 4.296836 | 3.000000 | | Calcium fluoride |
| 34 | -14.014264 | 7.000000 | | Air |
| 35 | -- | 11.160093 | | -- |
| Internal image | | | | |
| 36 | 102.631452 | 11.000000 | | Silica |
| 37 | 84.741293 | 27.845569 | | Air |
| 38 | 1.1470e+03 | 10.000000 | | Silica |
| 39 | Infinity | -10.000000 | | Reflect |
| 40 | 1.1470e+03 | -27.845569 | | Air |
| 41 | 84.741293 | -11.000000 | | Silica |
| 42 | 102.631452 | -11.160093 | | Air |
| 43 | 75.033466 | 11.160093 | | Reflect |
| 44 | 102.631452 | 11.000000 | | Silica |
| 45 | 84.741293 | 27.845569 | | Air |
| 46 | 1.1470e+03 | 10.000000 | | Silica |
| 47 | Infinity | 1.500000 | | Air |

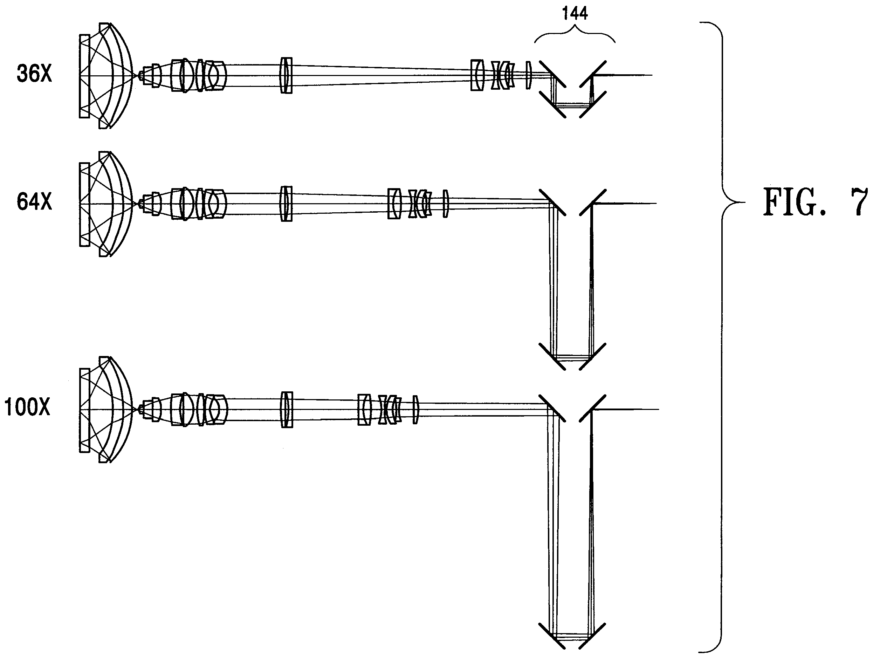

The third embodiment of zoom lenses provides linear zoom motion with a fixed sensor position by using the same lens design as the second embodiment and incorporating a "trombone" system of reflective elements so that the detector array does not move. FIG. 7 shows the 36X zoom arrangement of the lenses and reflective elements, the 64X zoom arrangement of the lenses and reflective elements and the 100X zoom arrangement of the lenses and reflective elements. The folding mirror group 144 is the "trombone" system of reflective elements. This folding mirror arrangement is just one example. Many other arrangements are possible, such as, using a different number of reflective elements.

Module Transfer Function curves (not shown) indicate that the FIG. 7 embodiment is essentially perfect at 64X and 100X, and is good at 36X. Zooming is done by moving a group of 6 lenses, as a unit, and also moving the arm of the trombone slide. Since the trombone motion only affects focus and the f# speed at this location is very slow, the accuracy of this motion could be very loose. One advantage of the trombone embodiment is that it significantly shortens the system. Another advantage is that there is only one zoom motion that involves active (non-flat) optical elements. And the other zoom motion, with the trombone slide, is insensitive to errors.

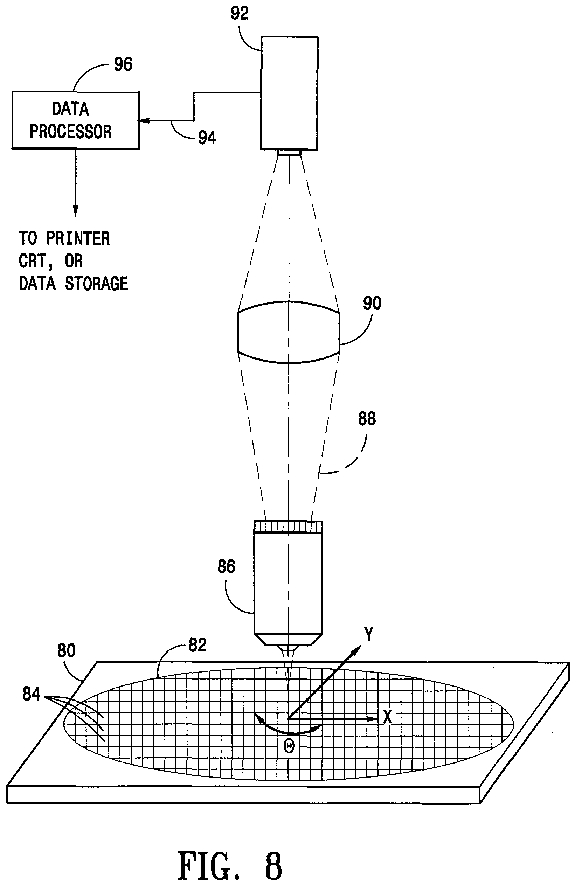

FIG. 8 is a schematic side view of a catadioptric imaging system with a zoom in an application for the inspection of semiconductor wafers. Platform 80 holds a wafer 82 that is composed of several integrated circuit dice 84. The catadioptric objective 86 transfers the light ray bundle 88 to the zooming tube lens 90 which produces an adjustable image received by the detector 92. The detector 92 converts the image to binary coded data and transfers the data over cable 94 to data processor 96.

The exemplary embodiments described herein are for purposes of illustration and are not intended to be limiting. Therefore, those skilled in the art will recognize that other embodiments could be practiced without departing from the scope and spirit of the claims set forth below.

## Claims

1. A high numerical aperture, broad spectral region catadioptric optical system **characterized in that** it comprises:
a tube lens section (139) which can zoom or change magnification without changing its higher-order lateral color aberration over a plurality of wavelengths, including at least one wavelength in the UV range; and
a non-zooming high numerical aperture catadioptric objective lens section (128) which compensates for uncorrected, but stationary during zooming or magnification change, residual chromatic aberrations of the tube lens section (139).

2. A system as in claim 1 wherein said lens sections (128, 139) use fused silica and calcium fluoride.

3. A system as in claim 1 wherein said lens sections (128, 139) use diffractive surfaces.

4. A system as in claim 1 further comprising a detector array (140) which does not move during zooming or a change in magnification of said tube lens section (139).

5. A system as in claim 1 wherein said objective lens section (128) comprises an achromatized field lens group (15; 127) which eliminates residual chromatic aberrations and compensates said tube lens section (139) for higher-order lateral color aberration, and wherein the combination of said lens sections (128, 139) corrects for chromatic variations in spherical aberration, coma, and astigmatism.

6. A high numerical aperture, broad spectral region catadioptric optical system as described in claim 1 wherein the catadioptric objective lens section (128) comprises:
a focusing lens group (11; 129) including a plurality of lens elements (21-27), with lens surfaces thereof disposed at first predetermined positions along an optical path of the system and having curvatures and said positions selected to focus ultraviolet light at an intermediate image (13) within the system, and simultaneously to also provide in combination with the rest of the system, high levels of correction of both image aberrations and chromatic variation of aberrations over a wavelength band including at least one wavelength in the UV range;
a field lens group (15; 127) with a net positive power aligned along said optical path proximate to said intermediate image (13), the field lens group (15; 127) including a plurality of lens elements with different dispersions, with lens surfaces disposed at second predetermined positions and having curvatures selected to provide substantial correction of chromatic aberrations including at least secondary longitudinal color and primary and secondary lateral color of the system over said wavelength band;
a catadioptric relay group (17; 122), including a combination of at least two reflective surfaces (41, 45; 123, 124) and at least one refractive surface disposed at third predetermined positions and having curvatures selected to form a real image of said intermediate image (13), such that, in combination with said focusing lens group (11; 129), primary longitudinal color of the system is substantially corrected over said wavelength band;
wherein the tube lens section (139) with lens surfaces thereof disposed at fourth predetermined positions along an optical path of the system.

7. A high numerical aperture, broad spectral region catadioptric optical system as described in claim 1 wherein said tube lens section (139) includes at least one diffractive lens.

8. A system as in claim 1 wherein said catadioptric optical system maintains near-diffraction-limited image quality over a magnification range of said system and over a UV spectral range sensed by said detector array (140).

9. A high numerical aperture, broad spectral region catadioptric optical system as described in claim 6 wherein said zooming tube lens section (139) comprises at least one diffractive lens.

10. A high numerical aperture, broad spectral region catadioptric optical system as described in claim 6:
wherein said field lens group (15; 127) includes a plurality of lens elements formed from at least two different refractive materials with different dispersions.

11. A high resolution, broadband UV imaging system comprising:
a detector array (140);
a broadband UV radiation source including a ultraviolet wavelength band of at least 0.23 - 0.29 microns; and
a high numerical aperture, broad spectral region catadioptric optical system (128, 139) as claimed in claim 1 capable of broadband UV zooming which maintains near-diffraction-limited image quality on said detector array (140).

12. A system as in claim 11 wherein said catadioptric optical system (128, 139) maintains near-diffraction-limited image quality over a magnification range of said system and over a UV spectral range sensed by said detector array (140).

13. A high numerical aperture, broad spectral region catadioptric optical system as described in claim 1 wherein the catadioptric objective lens section (128) comprises:
a focusing lens group (11; 129) including a plurality of lens elements (21-27), with refractive surfaces having curvatures and positions selected to focus ultraviolet light at an intermediate image (13) within the system, and simultaneously to also provide in combination with the rest of the system, high levels of correction of both image aberrations and chromatic variation of aberrations over a wavelength band including at least one wavelength in the UV range;
a field lens group (15; 127) with a net positive power aligned along said optical path proximate to said intermediate image (13), the field lens group (15; 127) including a plurality of lens elements, with refractive surfaces having curvatures selected to provide substantial correction of chromatic aberrations including at least secondary longitudinal color and primary and secondary lateral color of the system over said wavelength band;
a catadioptric relay group (17; 122), including a combination of at least two reflective surfaces (41, 45; 123, 124) and at least one refractive surface having curvatures selected to form a real image of said intermediate image (13), such that, in combination with said focusing lens group (11; 129), primary longitudinal color of the system is substantially corrected over said wavelength band; and
wherein the tube lens section (139) comprises refractive surfaces.

14. A high numerical aperture, broad spectral region catadioptric optical system as described in claim 13 wherein said tube lens section (139) is an all-refractive zooming tube lens section.

15. A high numerical aperture, broad spectral region catadioptric optical system as described in claim 13 wherein said tube lens section (139) comprises at least one diffractive lens.

16. A high resolution, broadband UV imaging system comprising:
a detector array (140) which can receive an image over a range of ultraviolet wavelengths;
a broadband UV radiation source providing a ultraviolet wavelength band; and
a high numerical aperture, broad spectral region catadioptric optical system a s in claim 1, the catadioptric objective lens section comprising:
a focusing lens group (11; 129) including a plurality of lens elements, with refractive surfaces having curvatures and positions selected to focus ultraviolet light at an intermediate image (13) within the system, and simultaneously to also provide in combination with the rest of the system, high levels of correction of both image aberrations and chromatic variation of aberrations over a wavelength band including one wavelength in the UV range,
a field lens group (15; 127) proximate to said intermediate image (13), the field lens group (15; 127) including a plurality of lens elements with refractive surfaces having curvatures selected to provide substantial correction of chromatic aberrations including at least secondary longitudinal color and primary and secondary lateral color of the system over said wavelength band,
a catadioptric relay group (17; 122), including a combination of at least two reflective surfaces (41, 45; 123, 124) and at least one refractive surface having curvatures selected to form a real image (13) of said intermediate image, such that, in combination with said focusing lens group (11; 129), primary longitudinal color of the system is substantially corrected over said wavelength band.

17. A system as in claim 16 wherein said catadioptric optical system includes compensation means for achromatizing a field lens and substantially eliminating residual chromatic aberrations and thereby substantially compensate said zooming tube lens section (139) for higher-order literal color aberration, and wherein the combination of said lens groups substantially corrects for chromatic variations in spherical aberration, coma, and astigmatism over said wavelength band.

18. A high numerical aperture, broad spectral region catadioptric optical system as described in claim 1 wherein the catadioptric objective lens section (128)
comprises:
a focusing lens group (11; 129) including a plurality of lens elements (21-27), with refractive surfaces thereof disposed to focus ultraviolet light within the system, and simultaneously to also provide in combination with the rest of the system, high levels of correction of both image aberrations and chromatic variation of aberrations over a wavelength band including at least one wavelength in the UV range;
a field lens group (15; 127) with a net positive power, the field lens group (15; 127) including a plurality of lens elements, with refractive surfaces having curvatures selected to provide substantial correction of chromatic aberrations including at least secondary longitudinal color and primary and secondary lateral color of the system over said wavelength band;

19. A system as in claim 18 wherein at least one of said lenses in the field lens group (15; 127) comprises a lens made of fused silica.

20. A system as in claim 18 wherein at least one of said lenses in the field lens group (15; 127) comprises a lens made of calcium fluoride.

21. A method for constructing a high numerical aperture, broad spectral region catadioptric optical system comprising the steps of:
providing a focusing lens group (11; 129) including a plurality of lens elements (21-27), with refractive surfaces thereof disposed at first predetermined positions along an optical path of the system and having curvatures and said positions selected to focus ultraviolet light at an intermediate image (13) within the system, and simultaneously to also provide in combination with the rest of the system, high levels of correction of both image aberrations and chromatic variation of aberrations over a wavelength band including at least one wavelength in the UV range;
providing a field lens group (15; 127) with a net positive power aligned along said optical path proximate to said intermediate image (13), the field lens group (15; 127) including a plurality of lens elements formed from at least two different refractive materials with different dispersions, with refractive surfaces of the lens elements of the field lens group (15; 127) disposed at second predetermined positions and having curvatures selected to provide substantial correction of chromatic aberrations including at least secondary longitudinal color and primary and secondary lateral color of the system over said wavelength band;
forming a real image (19) with a catadioptric relay group (17; 122), including a combination of at least two reflective surfaces (41, 45; 123, 124) and at least one refractive surface disposed at third predetermined positions and having curvatures selected to form a real image of said intermediate image (13), such that, in combination with said focusing lens group (11; 129), primary longitudinal color of the system is substantially corrected over said wavelength band; and zooming with a zooming tube lens section (139) which can zoom or change magnification without changing its higher-order lateral color aberration, and with lens surfaces thereof disposed at fourth predetermined positions along an optical path of the system, wherein at least one of the non-zooming groups of the high numerical aperture catadioptric optical system substantially compensates over said wavelength band for uncorrected, but stationary higher-order chromatic aberration residuals of the zooming tube lens section.

22. A method for constructing a high numerical aperture, broad spectral region catadioptric optical system as in claim 21 further comprising the step of:
constructing a catadioptric objective lens section (17; 122) comprising compensation means for achromatizing a field lens and for substantially eliminating residual chromatic aberrations and thereby substantially compensate said tube lens section (139) for higher-order lateral color aberration, and wherein the combination of said lens sections substantially corrects for chromatic variations in spherical aberration, coma, and astigmatism over said wavelength band.

## Patentansprüche

1. Katadioptrisches optisches System mit hoher numerischer Apertur und breitem Spektralbereich, **dadurch gekennzeichnet, dass** es Folgendes umfasst:
einen Röhrenlinsenabschnitt (139), der zoomen oder die Vergrößerung ändern kann, ohne seine laterale Farbaberration höherer Ordnung über eine Vielzahl von Wellenlängen zu ändern, einschließlich mindestens einer Wellenlänge im UV-Bereich; und
ein nicht-zoomender katadioptrischer Objektivlinsenabschnitt (128) mit hoher numerischer Apertur, der für nicht-korrigierte, jedoch beim Zoomen oder bei Vergrößerungsänderung stationäre, restliche chromatische Aberrationen des Röhrenlinsenabschnitts (139) kompensiert.

2. System nach Anspruch 1, wobei die Linsenabschnitte (128, 139) Quarzglas und Calciumfluorid nutzen.

3. System nach Anspruch 1, wobei die Linsenabschnitte (128, 139) diffraktive Oberflächen nutzen.

4. System nach Anspruch 1, ferner umfassend eine Detektoranordnung (140), die sich beim Zoomen oder bei einer Änderung der Vergrößerung des Röhrenlinsenabschnitts (139) nicht bewegt.

5. System nach Anspruch 1, wobei der Objektivlinsenabschnitt (128) eine achromatisierte Feldlinsengruppe (15; 127) umfasst, die restliche chromatische Aberrationen eliminiert und den Röhrenlinsenabschnitt (139) für eine laterale Farbaberration höherer Ordnung kompensiert und wobei die Kombination der Linsenabschnitte (128, 139) für chromatische Variationen bei sphärischer Aberration, Koma und Astigmatismus korrigiert.

6. Katadioptrisches optisches System mit hoher numerischer Apertur und breitem Spektralbereich nach Anspruch 1, wobei der katadioptrische Objektivlinsenabschnitt (128) Folgendes umfasst:
eine Fokussierlinsengruppe (11; 129) mit einer Vielzahl von Linsenelementen (21-27), deren Linsenoberflächen an ersten vorbestimmten Positionen entlang eines Strahlengangs des Systems angeordnet sind und Krümmungen aufweisen und die Positionen ausgewählt sind, um Ultraviolettlicht an einem Zwischenbild (13) innerhalb des Systems zu fokussieren und gleichzeitig auch in Kombination mit dem Rest des Systems ein hohes Maß an Korrektur sowohl von Abbildungsaberrationen als auch chromatischer Variation von Aberrationen über ein Wellenlängenband mit mindestens einer Wellenlänge im UV-Bereich bereitzustellen;
eine Feldlinsengruppe (15; 127) mit einer positiven Nettoleistung, die entlang des Strahlengangs nahe dem Zwischenbild (13) ausgerichtet ist, wobei die Feldlinsengruppe (15; 127) eine Vielzahl von Linsenelementen mit verschiedenen Dispersionen beinhaltet, wobei Linsenoberflächen an zweiten vorbestimmten Positionen angeordnet sind und Krümmungen aufweisen, die ausgewählt sind, um eine wesentliche Korrektur von chromatischen Aberrationen einschließlich mindestens sekundärer longitudinaler Farbe und primärer und sekundärer lateraler Farbe des Systems über dem Wellenlängenband bereitzustellen;
eine katadioptrische Relaisgruppe (17; 122), die eine Kombination von mindestens zwei reflektierenden Oberflächen (41, 45; 123, 124) und mindestens einer Brechungsfläche beinhaltet, die an dritten vorbestimmten Positionen angeordnet sind und Krümmungen aufweisen, die ausgewählt sind, um eine reale Abbildung des Zwischenbildes (13) zu bilden, so dass in Kombination mit der Fokussierlinsengruppe (11; 129) eine primäre longitudinale Farbe des Systems über das Wellenlängenband im Wesentlichen korrigiert wird;
wobei bei dem Röhrenlinsenabschnitt (139) Linsenoberflächen davon an vierten vorbestimmten Positionen entlang eines Strahlengangs des Systems angeordnet sind.

7. Katadioptrisches optisches System mit hoher numerischer Apertur und breitem Spektralbereich nach Anspruch 1, wobei der Röhrenlinsenabschnitt (139) mindestens eine diffraktive Linse beinhaltet.

8. System nach Anspruch 1, wobei das katadioptrische optische System eine nahezu beugungsbegrenzte Bildqualität über einen Vergrößerungsbereich des Systems und über einen von der Detektoranordnung (140) erfassten UV-Spektralbereich beibehält.

9. Katadioptrisches optisches System mit hoher numerischer Apertur und breitem Spektralbereich nach Anspruch 6, wobei der Zoomröhrenlinsenabschnitt (139) mindestens eine diffraktive Linse umfasst.

10. Katadioptrisches optisches System mit hoher numerischer Apertur und breitem Spektralbereich nach Anspruch 6:
wobei die Feldlinsengruppe (15; 127) eine Vielzahl von Linsenelementen beinhaltet, die aus mindestens zwei verschiedenen refraktiven Materialien mit verschiedenen Dispersionen gebildet ist.

11. Hochauflösendes Breitband-UV-Abbildungssystem, umfassend:
eine Detektoranordnung (140);
eine Breitband-UV-Strahlungsquelle mit einem Ultraviolett-Wellenlängenband von mindestens 0,23 - 0,29 Mikrometern; und
ein katadioptrisches optisches System (128, 139) mit hoher numerischer Apertur und breitem Spektralbereich nach Anspruch 1, das Breitband-UV-Zoomen kann, wobei eine nahezu beugungsbegrenzte Bildqualität auf der Detektoranordnung (140) beibehalten wird.

12. System nach Anspruch 11, wobei das katadioptrische optische System (128, 139) eine nahezu beugungsbegrenzte Bildqualität über einen Vergrößerungsbereich des Systems und über einen von der Detektoranordnung (140) erfassten UV-Spektralbereich beibehält.

13. Katadioptrisches optisches System mit hoher numerischer Apertur und breitem Spektralbereich nach Anspruch 1, wobei der katadioptrische Objektivlinsenabschnitt (128) Folgendes umfasst:
eine Fokussierlinsengruppe (11; 129) mit einer Vielzahl von Linsenelementen (21-27) mit Brechungsflächen, die Krümmungen aufweisen, und Positionen, die ausgewählt sind, um Ultraviolettlicht an einem Zwischenbild (13) innerhalb des Systems zu fokussieren und gleichzeitig auch in Kombination mit dem Rest des Systems ein hohes Maß an Korrektur sowohl von Abbildungsaberrationen als auch chromatischer Variation von Aberrationen über ein Wellenlängenband mit mindestens einer Wellenlänge im UV-Bereich bereitzustellen;
eine Feldlinsengruppe (15; 127) mit einer positiven Nettoleistung, die entlang des Strahlengangs nahe dem Zwischenbild (13) ausgerichtet ist, wobei die Feldlinsengruppe (15; 127) eine Vielzahl von Linsenelementen beinhaltet, wobei Brechungsflächen Krümmungen aufweisen, die ausgewählt sind, um eine wesentliche Korrektur von chromatischen Aberrationen einschließlich mindestens sekundärer longitudinaler Farbe und primärer und sekundärer lateraler Farbe des Systems über dem Wellenlängenband bereitzustellen;
eine katadioptrische Relaisgruppe (17; 122) mit einer Kombination von mindestens zwei reflektierenden Oberflächen (41, 45; 123, 124) und mindestens einer Brechungsfläche, die Krümmungen aufweisen, die ausgewählt sind, um eine reale Abbildung des Zwischenbildes (13) zu bilden, so dass in Kombination mit der Fokussierlinsengruppe (11; 129) eine primäre longitudinale Farbe des Systems über das Wellenlängenband im Wesentlichen korrigiert wird; und
wobei der Röhrenlinsenabschnitt (139) Brechungsflächen umfasst.

14. Katadioptrisches optisches System mit hoher numerischer Apertur und breitem Spektralbereich nach Anspruch 12, wobei der Röhrenlinsenabschnitt (139) ein Röhrenlinsenabschnitt mit ausschließlich refraktivem Zoomen ist.

15. Katadioptrisches optisches System mit hoher numerischer Apertur und breitem Spektralbereich nach Anspruch 12, wobei der Röhrenlinsenabschnitt (139) mindestens eine diffraktive Linse umfasst.

16. Hochauflösendes Breitband-UV-Abbildungssystem, umfassend:
eine Detektoranordnung (140), die ein Bild über einen Ultraviolettwellenlängenbereich empfangen kann;
eine Breitband-UV-Strahlungsquelle, die ein Ultraviolett-Wellenlängenband bereitstellt; und
ein katadioptrisches optisches System mit hoher numerischer Apertur und breitem Spektralbereich nach Anspruch 1, wobei der katadioptrische Objektivlinsenabschnitt Folgendes umfasst:
eine Fokussierlinsengruppe (11; 129) mit einer Vielzahl von Linsenelementen mit Brechungsflächen, die Krümmungen aufweisen, und Positionen, die ausgewählt sind, um Ultraviolettlicht an einem Zwischenbild (13) innerhalb des Systems zu fokussieren und gleichzeitig auch in Kombination mit dem Rest des Systems ein hohes Maß an Korrektur sowohl von Abbildungsaberrationen als auch chromatischer Variation von Aberrationen über ein Wellenlängenband mit mindestens einer Wellenlänge im UV-Bereich bereitzustellen;
eine Feldlinsengruppe (15; 127) nahe dem Zwischenbild (13), wobei die Feldlinsengruppe (15; 127) eine Vielzahl von Linsenelementen beinhaltet, wobei Brechungsflächen Krümmungen aufweisen, die ausgewählt sind, um eine wesentliche Korrektur von chromatischen Aberrationen einschließlich mindestens sekundärer longitudinaler Farbe und primärer und sekundärer lateraler Farbe des Systems über dem Wellenlängenband bereitzustellen;
eine katadioptrische Relaisgruppe (17; 122) mit einer Kombination von mindestens zwei reflektierenden Oberflächen (41, 45; 123, 124) und mindestens einer Brechungsfläche, die Krümmungen aufweisen, die ausgewählt sind, um eine reale Abbildung des Zwischenbildes (13) zu bilden, so dass in Kombination mit der Fokussierlinsengruppe (11; 129) eine primäre longitudinale Farbe des Systems über das Wellenlängenband im Wesentlichen korrigiert wird.

17. System nach Anspruch 15, wobei das katadioptrische optische System Kompensationsmittel zum Achromatisieren einer Feldlinse und zum im wesentlichen Eliminieren restlicher chromatischer Aberrationen beinhaltet und dadurch den Röhrenlinsenabschnitt (139) für eine laterale Farbaberration höherer Ordnung im Wesentlichen kompensiert und wobei die Kombination der Linsengruppen chromatische Variationen bei sphärischer Aberration, Koma und Astigmatismus über das Wellenlängenband im Wesentlichen korrigiert.

18. Katadioptrisches optisches System mit hoher numerischer Apertur und breitem Spektralbereich nach Anspruch 1, wobei der katadioptrische Objektivlinsenabschnitt (128) Folgendes umfasst:
eine Fokussierlinsengruppe (11; 129) mit einer Vielzahl von Linsenelementen (21-27), deren Brechungsflächen angeordnet sind, um Ultraviolettlicht innerhalb des Systems zu fokussieren und gleichzeitig auch in Kombination mit dem Rest des Systems ein hohes Maß an Korrektur sowohl von Abbildungsaberrationen als auch chromatischer Variation von Aberrationen über ein Wellenlängenband mit mindestens einer Wellenlänge im UV-Bereich bereitzustellen;
eine Feldlinsengruppe (15; 127) mit einer positiven Nettoleistung, wobei die Feldlinsengruppe (15; 127) eine Vielzahl von Linsenelementen beinhaltet, wobei Brechungsflächen Krümmungen aufweisen, die ausgewählt sind, um eine wesentliche Korrektur von chromatischen Aberrationen einschließlich mindestens sekundärer longitudinaler Farbe und primärer und sekundärer lateraler Farbe des Systems über dem Wellenlängenband bereitzustellen;

19. System nach Anspruch 17, wobei mindestens eine der Linsen in der Feldlinsengruppe (15; 127) eine aus Quarzglas gefertigte Linse umfasst.

20. System nach Anspruch 17, wobei mindestens eine der Linsen in der Feldlinsengruppe (15; 127) eine aus Calciumfluorid gefertigte Linse umfasst.

21. Verfahren zum Konstruieren eines katadioptrischen optischen Systems mit hoher numerischer Apertur und breitem Spektralbereich, das die folgenden Schritte umfasst:
Bereitstellen einer Fokussierlinsengruppe (11; 129) mit einer Vielzahl von Linsenelementen (21-27), deren Brechungsflächen an ersten vorbestimmten Positionen entlang eines Strahlengangs des Systems angeordnet sind und Krümmungen aufweisen und die Positionen ausgewählt sind, um Ultraviolettlicht an einem Zwischenbild (13) innerhalb des Systems zu fokussieren und gleichzeitig auch in Kombination mit dem Rest des Systems ein hohes Maß an Korrektur sowohl von Abbildungsaberrationen als auch chromatischer Variation von Aberrationen über ein Wellenlängenband mit mindestens einer Wellenlänge im UV-Bereich bereitzustellen;
Bereitstellen einer Feldlinsengruppe (15; 127) mit einer positiven Nettoleistung, die entlang des Strahlengangs nahe dem Zwischenbild (13) ausgerichtet ist, wobei die Feldlinsengruppe (15; 127) eine Vielzahl von Linsenelementen beinhaltet, die aus mindestens zwei verschiedenen refraktiven Materialien mit verschiedenen Dispersionen gebildet sind, wobei Brechungsflächen der Linsenelemente der Feldlinsengruppe (15; 127) an zweiten vorbestimmten Positionen angeordnet sind und Krümmungen aufweisen, die ausgewählt sind, um eine wesentliche Korrektur von chromatischen Aberrationen einschließlich mindestens sekundärer longitudinaler Farbe und primärer und sekundärer lateraler Farbe des Systems über dem Wellenlängenband bereitzustellen;
Bilden einer realen Abbildung (19) mit einer katadioptrischen Relaisgruppe (17; 122), die eine Kombination von mindestens zwei reflektierenden Oberflächen (41, 45; 123, 124) und mindestens einer Brechungsfläche beinhaltet, die an dritten vorbestimmten Positionen angeordnet sind und Krümmungen aufweisen, die ausgewählt sind, um eine reale Abbildung des Zwischenbildes (13) zu bilden, so dass in Kombination mit der Fokussierlinsengruppe (11; 129) eine primäre longitudinale Farbe des Systems über das Wellenlängenband im Wesentlichen korrigiert wird; und Zoomen mit einem Zoomröhrenlinsenabschnitt (139), der Zoomen oder eine Vergrößerung ändern kann, ohne seine laterale Farbaberration höherer Ordnung zu ändern und wobei Linsenoberflächen davon an vierten vorbestimmten Positionen entlang eines Strahlenganges des Systems angeordnet sind, wobei mindestens eine der nicht-zoomenden Gruppen des katadioptrischen optischen Systems mit hoher numerischer Apertur nicht-korrigierte, jedoch stationäre restliche chromatische Aberrationen höherer Ordnung des Zoomröhrenlinsenabschnitts im Wesentlichen kompensiert.

22. Verfahren zum Konstruieren eines katadioptrischen optischen Systems mit hoher numerischer Apertur und breitem Spektralbereich nach Anspruch 20, das ferner den folgenden Schritt umfasst:
Konstruieren eines katadioptrischen Objektivlinsenabschnitts (17; 122), umfassend Kompensationsmittel zum Achromatisieren einer Feldlinse und zum im Wesentlichen Eliminieren restlicher chromatischer Aberrationen und dadurch im Wesentlichen Kompensieren des Röhrenlinsenabschnitts (139) für eine laterale Farbaberration höherer Ordnung und wobei die Kombination der Linsenabschnitte chromatische Variationen bei sphärischer Aberration, Koma und Astigmatismus über das Wellenlängenband im Wesentlichen korrigiert.

## Revendications

1. Système optique catadioptrique à large région spectrale et à ouverture numérique élevée **caractérisé en ce qu'**il comprend :
une partie lentille de tube (139) qui peut zoomer ou changer de grossissement sans changer son aberration chromatique latérale d'ordre supérieur sur une pluralité de longueurs d'onde, comprenant au moins une longueur d'onde dans la gamme d'UV ; et
une partie lentille d'objectif catadioptrique à ouverture numérique élevée sans zoom (128) qui compense les aberrations chromatiques résiduelles non corrigées mais stationnaires pendant le zoom ou le changement de grossissement de la partie lentille de tube (139).

2. Système selon la revendication 1, dans lequel lesdites parties de lentille (128, 139) utilisent de la silice fondue et du fluorure de calcium.

3. Système selon la revendication 1, dans lequel lesdites parties de lentilles (128, 139) utilisent des surfaces diffractives.

4. Système selon la revendication 1, comprenant en outre un réseau de détecteurs (140) qui ne bouge pas pendant le zoom ou le changement de grossissement de ladite partie de lentille de tube (139).

5. Système selon la revendication 1, dans lequel ladite partie de lentille d'objectif (128) comprend un groupe de lentilles de champ achromatiques (15 ; 127) qui élimine les aberrations chromatiques résiduelles et compense ladite partie de lentille de tube (139) concernant l'aberration chromatique latérale d'ordre supérieure, et dans lequel la combinaison desdites parties de lentilles (128, 139) corrigent les variations chromatiques dans l'aberration sphérique, la coma et l'astigmatisme.

6. Système optique catadioptrique à large région spectrale et à ouverture numérique élevée selon la revendication 1, dans lequel la partie de lentille d'objectif catadioptrique (128) comprend :
un groupe de lentilles de focalisation (11 ; 129) comprenant une pluralité d'éléments à lentille (21-27), les surfaces de lentille de ceux-ci étant placées dans des premières positions prédéterminées le long d'un chemin optique du système et ayant des courbures et lesdites positions sélectionnées pour focaliser la lumière ultraviolette sur une image intermédiaire (13) dans le système et, simultanément, pour fournir également, en combinaison avec le reste du système, des niveaux élevés de correction à la fois des aberrations de l'image et de la variation chromatique des aberrations sur une bande de longueurs d'onde comprenant au moins une longueur d'onde dans la gamme UV ;
un groupe de lentilles de champ (15 ; 127) ayant une puissance positive nette alignée le long dudit chemin optique à proximité de ladite image intermédiaire (13), le groupe de lentilles de champ (15 ; 127) comprenant une pluralité d'éléments à lentille possédant des dispersions différentes, les surfaces de lentille étant placées dans des deuxièmes positions prédéterminées et ayant des courbures sélectionnées pour fournir une correction sensible d'aberrations chromatiques comprenant au moins une couleur longitudinale secondaire et une couleur latérale primaire et secondaire du système sur ladite bande de longueurs d'onde ;
un groupe de relais catadioptrique (17 ; 122), comprenant une combinaison d'au moins deux surfaces réfléchissantes (41, 45 ; 123, 124) et d'au moins une surface réfringente placées dans des troisièmes positions prédéterminées et ayant des courbures sélectionnées pour former une image réelle de ladite image intermédiaire (13), de telle sorte, qu'en combinaison avec ledit groupe de lentilles de focalisation (11 ;129) la couleur longitudinale primaire du système est sensiblement corrigée sur ladite bande de longueurs d'onde ;
dans lequel la partie de lentille de tube (139) a des surfaces de lentille placées dans des quatrièmes positions prédéterminées le long d'un chemin optique du système.

7. Système optique catadioptrique à large région spectrale et à ouverture numérique élevée selon la revendication 1, dans lequel ladite partie de lentille de tube (139) comprend au moins une lentille diffractive.

8. Système selon la revendication 1, dans lequel ledit système optique catadioptrique maintient une qualité d'image à diffraction quasi-limitée sur une plage de grossissement dudit système et sur une gamme spectrale d'UV captée par ledit réseau de détecteurs (140).

9. Système optique catadioptrique à large région spectrale et à ouverture numérique élevée selon la revendication 6, dans lequel ladite partie de lentille de tube zoom (139) comprend au moins une lentille diffractive.

10. Système optique catadioptrique à large région spectrale et à ouverture numérique élevée selon la revendication 6 :
dans lequel ledit groupe de lentilles de champ (15 ; 127) comprend une pluralité d'éléments à lentille formée d'au moins deux matériaux réfringents différents possédant des dispersions différentes.

11. Système d'imagerie à UV large bande et résolution élevée, comprenant :
un réseau de détecteurs (140) ;
une source de rayonnement UV à large bande comprenant une bande de longueurs d'onde d'ultraviolets d'au moins 0,23 - 0,29 microns ; et
un système optique catadioptrique à large région spectrale et à ouverture numérique élevée (128, 139) selon la revendication 1 à effet de zoom à UV à large bande qui maintient une qualité d'image à diffraction quasi-limitée sur le réseau de détecteurs (140).

12. Système selon la revendication 11, dans lequel ledit système optique catadioptrique (128, 139) maintient une qualité d'image à diffraction quasi-limitée sur une plage de grossissement dudit système et sur une gamme spectrale d'UV captée par ledit réseau de détecteurs (140).

13. Système optique catadioptrique à large région spectrale et à ouverture numérique élevée selon la revendication 1, dans lequel la partie de lentille d'objectif catadioptrique (128) comprend :
un groupe de lentilles de focalisation (11 ; 129) comprenant une pluralité d'éléments à lentille (21-27), les surfaces réfringentes ayant des courbures et des positions sélectionnées pour focaliser la lumière ultraviolette sur une image intermédiaire (13) dans le système et, simultanément, pour fournir également, en combinaison avec le reste du système, des niveaux élevés de correction à la fois des aberrations de l'image et de la variation chromatique des aberrations sur une bande de longueurs d'onde comprenant au moins une longueur d'onde dans la gamme UV ;
un groupe de lentilles de champ (15 ; 127) ayant une puissance positive nette alignée le long dudit chemin optique à proximité de ladite image intermédiaire (13), le groupe de lentilles de champ (15 ; 127) comprenant une pluralité d'éléments à lentille possédant des surfaces réfringentes ayant des courbures sélectionnées pour fournir une correction sensible d'aberrations chromatiques comprenant au moins une couleur longitudinale secondaire et une couleur latérale primaire et secondaire du système sur ladite bande de longueurs d'onde ;
un groupe de relais catadioptriques (17 ; 122), comprenant une combinaison d'au moins deux surfaces réfléchissantes (41, 45 ; 123, 124) et d'au moins une surface réfringente ayant des courbures sélectionnées pour former une image réelle de ladite image intermédiaire (13), de telle sorte, qu'en combinaison avec ledit groupe de lentilles de focalisation (11 ; 129) la couleur longitudinale primaire du système est sensiblement corrigée sur ladite bande de longueurs d'onde ; et
dans lequel la partie lentille de tube (139) comprend des surfaces réfringentes.

14. Système optique catadioptrique à large région spectrale et à ouverture numérique élevée selon la revendication 12, dans lequel ladite partie lentille de tube (139) est une partie lentille de tube zoom entièrement réfringente.

15. Système optique catadioptrique à large région spectrale et à ouverture numérique élevée selon la revendication 12, dans lequel ladite partie de lentille de tube (139) comprend au moins une lentille diffractive.

16. Système d'imagerie UV à large bande et à résolution élevée, comprenant :
un réseau de détecteurs (140) qui peut recevoir une image sur une gamme de longueurs d'onde d'ultraviolets ;
une source de rayonnement UV à large bande fournissant une bande de longueurs d'onde d'ultraviolets ; et
un système optique catadioptrique à large région spectrale et à ouverture numérique élevée selon la revendication 1, la partie lentille d'objectif catadioptrique comprenant :
un groupe de lentilles de focalisation (11 ; 129) comprenant une pluralité d'éléments à lentille, les surfaces réfringentes ayant des courbures et des positions sélectionnées pour focaliser la lumière ultraviolette sur une image intermédiaire (13) dans le système et, simultanément, pour fournir également, en combinaison avec le reste du système, des niveaux élevés de correction à la fois des aberrations de l'image et de la variation chromatique des aberrations sur une bande de longueurs d'onde comprenant une longueur d'onde dans la gamme d'UV,
un groupe de lentilles de champ (15 ; 127) à proximité de ladite image intermédiaire (13), le groupe de lentilles de champ (15 ; 127) comprenant une pluralité d'éléments à lentille possédant des surfaces réfringentes ayant des courbures sélectionnées pour fournir une correction sensible d'aberrations chromatiques comprenant au moins une couleur longitudinale secondaire et une couleur latérale primaire et secondaire du système sur ladite bande de longueurs d'onde,
un groupe de relais catadioptriques (17 ; 122), comprenant une combinaison d'au moins deux surfaces réfléchissantes (41, 45 ; 123, 124) et d'au moins une surface réfringente ayant des courbures sélectionnées pour former une image réelle (13) de ladite image intermédiaire, de telle sorte, qu'en combinaison avec ledit groupe de lentilles de focalisation (11 ; 129) la couleur longitudinale primaire du système est sensiblement corrigée sur ladite bande de longueurs d'onde.

17. Système selon la revendication 15, dans lequel ledit système optique catadioptrique comprend un moyen de compensation pour achromatiser une lentille et éliminer sensiblement les aberrations chromatiques résiduelles et, ce faisant, compenser sensiblement ladite partie de lentille de tube zoom (139) concernant l'aberration chromatique latérale d'ordre supérieur, et dans lequel la combinaison desdits groupes de lentilles corrige sensiblement les variations chromatiques dans l'aberration sphérique, la coma et l'astigmatisme sur ladite bande de longueurs d'onde.

18. Système optique catadioptrique à large région spectrale et à ouverture numérique élevée selon la revendication 1, dans lequel la partie lentille d'objectif catadioptrique (128) comprend :
un groupe de lentilles de focalisation (11 ; 129) comprenant une pluralité d'éléments à lentille (21-27), les surface réfringentes de ceux-ci étant placées de sorte à focaliser la lumière ultraviolette dans le système et, simultanément, pour fournir également, en combinaison avec le reste du système, des niveaux élevés de correction à la fois des aberrations de l'image et de la variation chromatique des aberrations sur une bande de longueurs d'onde comprenant au moins une longueur d'onde dans la gamme d'UV ;
un groupe de lentilles de champ (15 ; 127) ayant une puissance positive nette, le groupe de lentilles de champ (15 ; 127) comprenant une pluralité d'éléments à lentille possédant des surfaces réfringentes ayant des courbures sélectionnées pour fournir une correction sensible d'aberrations chromatiques comprenant au moins une couleur longitudinale secondaire et une couleur latérale primaire et secondaire du système sur ladite bande de longueurs d'onde ;

19. Système selon la revendication 17, dans lequel au moins une desdites lentilles du groupe de lentilles de champ (15 ; 127) comprend une lentille fabriquée en silice fondue.

20. Système selon la revendication 17, dans lequel au moins une desdites lentilles du groupe de lentilles de champ (15 ; 127) comprend une lentille fabriquée en fluorure de calcium.

21. Procédé de construction d'un système optique catadioptrique à large région spectrale et à ouverture numérique élevée comprenant les étapes consistant à :
fournir un groupe de lentilles de focalisation (11 ; 129) comprenant une pluralité d'éléments à lentille (21-27), les surface réfringentes de ceux-ci étant placées dans des premières positions prédéterminées le long d'un chemin optique du système et ayant des courbures et lesdites positions sélectionnées pour focaliser la lumière ultraviolette sur une image intermédiaire (13) dans le système et, simultanément, pour fournir également, en combinaison avec le reste du système, des niveaux élevés de correction à la fois des aberrations de l'image et de la variation chromatique des aberrations sur une bande de longueurs d'onde comprenant au moins une longueur d'onde dans la gamme UV ;
fournir un groupe de lentilles de champ (15 ; 127) ayant une puissance positive nette alignée le long dudit chemin optique à proximité de ladite image intermédiaire (13), le groupe de lentilles de champ (15 ; 127) comprenant une pluralité d'éléments à lentille formés d'au moins deux matériaux réfringents différents possédant des dispersions différentes, les surfaces réfringentes des éléments à lentille du groupe de lentilles de champ (15 ; 127) étant placées dans des deuxièmes positions prédéterminées et ayant des courbures sélectionnées pour fournir une correction sensible d'aberrations chromatiques comprenant au moins une couleur longitudinale secondaire et une couleur latérale primaire et secondaire du système sur ladite bande de longueurs d'onde ;
la formation d'une image réelle (19) avec un groupe de relais catadioptriques (17 ; 122) comprenant une combinaison d'au moins deux surfaces réfléchissantes (41, 45 ; 123, 124) et d'au moins une surface réfringente placées dans des troisièmes positions prédéterminées et ayant des courbures sélectionnées pour former une image réelle de ladite image intermédiaire (13), de telle sorte, qu'en combinaison avec ledit groupe de lentilles de focalisation (11 ;129) la couleur longitudinale primaire du système est sensiblement corrigée sur ladite bande de longueurs d'onde ; et zoomer avec une partie de lentille de tube zoom (139) qui peut zoomer ou changer de grossissement sans changer son aberration chromatique latérale d'ordre supérieur sur une pluralité de longueurs d'onde, et des surfaces de lentille de cette partie étant placées dans des quatrièmes positions prédéterminées le long d'un chemin optique du système, dans lequel au moins un des groupes sans zoom du système optique catadioptrique à ouverture numérique élevée compense sensiblement les aberrations chromatiques résiduelles d'ordre élevé non corrigées mais stationnaires sur ladite bande de longueurs d'onde de la partie lentille de tube zoom.

22. Procédé de construction d'un système optique catadioptrique à large région spectrale et à ouverture numérique élevée selon la revendication 20, comprenant en outre l'étape consistant à :
construire une partie de lentille d'objectif catadioptrique (17 ; 122) comprenant un moyen de compensation pour achromatiser une lentille de champ et pour éliminer sensiblement les aberrations chromatiques résiduelles et, ce faisant, compenser sensiblement ladite partie lentille de tube (139) concernant l'aberration chromatique latérale d'ordre supérieur, et dans lequel la combinaison desdits groupes de lentilles corrige sensiblement les variations chromatiques dans l'aberration sphérique, la coma et l'astigmatisme sur ladite bande de longueurs d'onde.
